Europäisches Patentamt

European Patent Office

Office européen des brevets

(19)

(11) **EP 1 667 238 A1**

(12) **EUROPEAN PATENT APPLICATION**
published in accordance with Art. 158(3) EPC

(43) Date of publication:
07.06.2006 Bulletin 2006/23

(51) Int Cl.:
*H01L 29/786* (1995.01)    *H01L 29/06* (1974.07)

(21) Application number: 04772967.8

(86) International application number:
**PCT/JP2004/013285**

(22) Date of filing: 07.09.2004

(87) International publication number:
**WO 2005/027226 (24.03.2005 Gazette 2005/12)**

(84) Designated Contracting States:
**DE FR GB**

(30) Priority: **12.09.2003 JP 2003320709**
**26.09.2003 JP 2003335051**

(71) Applicant: **SONY CORPORATION**
**Tokyo 141-0001 (JP)**

(72) Inventors:
• **SHIRAISHI, Masashi,**
**c/o Sony Corporation**
**Shinagawa-ku, Tokyo (JP)**

• **ATA, Masafumi,**
**c/o Sony Corporation**
**Shinagawa-ku, Tokyo (JP)**

(74) Representative: **Müller - Hoffmann & Partner**
**Patentanwälte**
**Innere Wiener Strasse 17**
**81667 München (DE)**

(54) **METHOD FOR MANUFACTURING FIELD EFFECT SEMICONDUCTOR DEVICE**

(57)    There is provided a method for producing a field effect semiconductor device, e.g., a field effect transistor 6 using carbon nanotubes in a channel layer 5, wherein the method includes the step of subjecting the carbon nanotubes to plasma treatment to change a physical or chemical state of the carbon nanotubes. Thus, there can be provided a method which is advantageous in that the method easily produces a field effect semiconductor device which has a current path, e.g., a channel layer, having carbon nanotubes uniformly dispersed therein, and which is prevented from suffering deterioration of the device characteristics due to the formation of bundles of carbon nanotubes.

FIG. 1A

BEFORE PLASMA TREATMENT

FIG. 1B

AFTER PLASMA TREATMENT

EP 1 667 238 A1

**Description**

Technical Field

The present invention relates to a method for producing a field effect semiconductor device, such as a field effect transistor.

Background Art

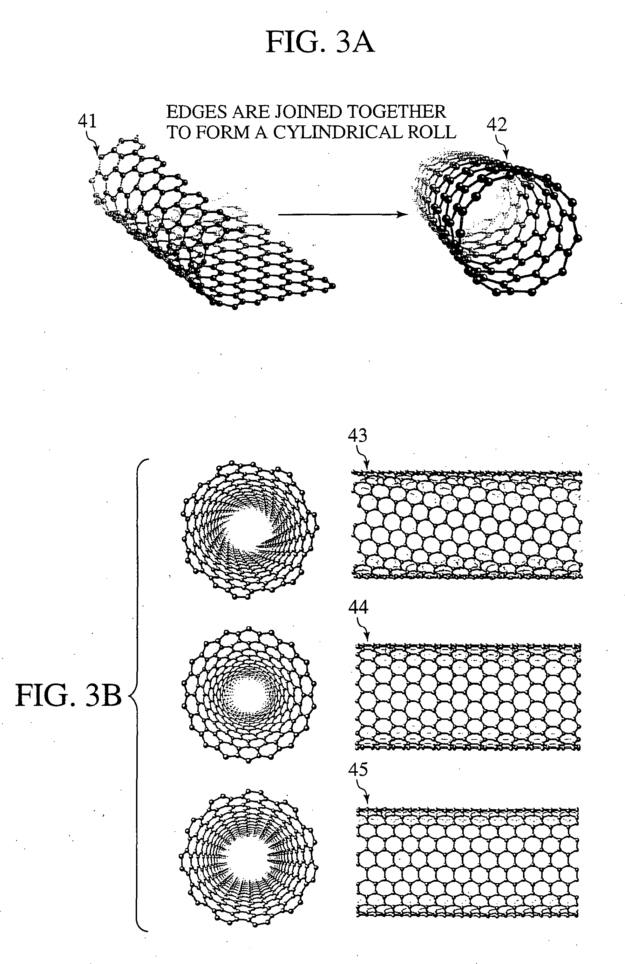

Carbon nanotubes are tubular carbon molecules composed solely of carbon, discovered by Iijima in 1991, and the wall of the carbon nanotube is ideally composed solely of carbon 6-membered rings. As shown in FIG. 3A, it is considered that a single-wall carbon nanotube 42 is a seamless cylindrical roll formed by joining together the edges of a rectangular graphene sheet 41. A multi-wall carbon nanotube is composed of a number of cylindrical carbon nanotubes having different diameters, which are stacked on one another in a telescopic way.

As shown in FIG. 3B, in addition to the diameter, depending on the direction of joining the edges of the graphene sheet, namely, the orientation of carbon 6-membered rings with respect to the circumferential direction of the tube, the carbon nanotubes are classified into various carbon nanotubes having different chirality, for example, chiral carbon nanotubes 43, zigzag carbon nanotubes 44, armchair carbon nanotubes 45, and the like.

A field effect transistor having a channel layer composed of the single-wall carbon nanotubes can be produced by allowing the single-wall carbon nanotubes to grow randomly between source/drain electrodes by a chemical vapor deposition (CVD) process (see, for example, APPLIED PHYSICS LETTERS 82, E. S. Snow et al, (2003), 2145).

Specifically, methane gas as a carbon source is heated to 50°C to 80°C using nickelocene as a catalyst to prepare nanotubes, and the nanotubes are deposited on a channel layer to produce a device.

In addition, APPLIED PHYSICS LETTERS 82 shows that a field effect transistor (FET) having a channel layer composed of single-wall carbon nanotubes in a density as small as about one tube/$\mu$m$^2$ exhibits such excellent FET characteristics that the On/Off ratio is a value in five digits and the mobility is 7 cm$^2$/Vs. This is an example utilizing the ballistic conduction of the single-wall carbon nanotubes.

However, the carbon nanotubes form together a thick bundle due to a strong van der Waals force, which makes it difficult to divide the bundle into individual carbon nanotubes. The formation of bundles of carbon nanotubes increases the number of carrier conduction paths as a channel material, causing the device performance (device characteristics) to be poor. In other words, a treatment for forming a state in which the carbon nanotubes are uniformly dispersed is required.

The bundle structure of nanotubes makes it difficult to achieve a desired degree of dispersion of the nanotubes both when the carbon nanotubes are allowed to grow between the source/drain electrodes by a CVD process and when the carbon nanotubes are dispersed.

Furthermore, in the above-mentioned conventional technique, carbon nanotubes are merely allowed to grow directly between the source/drain electrodes by a CVD process, and therefore the resultant carbon nanotubes have an unfavorable wall structure such that the walls are undulate or contain a carbon 5-membered ring or carbon 7-membered ring. In a field effect transistor produced using the carbon nanotubes having such a wall structure, electrons are likely to be scattered, thus lowering the mobility. Further, the production process for the transistor is not easy.

For solving the problem to achieve a field effect transistor having much higher mobility, the use of carbon nanotubes prepared by, for example, a laser ablation process which is a high-temperature synthesis method is advantageous. The carbon nanotubes prepared by a laser ablation process have such excellent properties that the wall structure of each carbon nanotube is composed substantially solely of carbon 6-membered rings and has fewer defects, and this fact has been confirmed by the examination under an electron microscope (M. Shiraishi et al., Chem. Phys. Lett. 358 (2002) 213.).

However, the carbon nanotubes of this type need a purification process, and the carbon nanotubes form together a thick bundle due to a van der Waals force during the purification. Specifically, in the purification process, the carbon nanotubes are heated in aqueous hydrogen peroxide under reflux at 100°C for 5 hours and then subjected to ultrasonic treatment in an NaOH solution. The formation of bundles of the carbon nanotubes during the purification process increases the number of conduction paths as a channel material, causing the device performance (device characteristics) to be poor. In other words, a treatment for forming a state in which the carbon nanotubes are uniformly dispersed to prevent formation of thick bundles is required. (Studies are being made on the so-called organic semiconductor field effect transistors as substitutes for the silicon devices since the organic semiconductor field effect transistors are advantageous from the viewpoint of cost and have molding flexibility when using a plastic substrate.)

DISCLOSURE OF THE INVENTION

The present invention has been achieved for solving the above problems, and a task is to provide a method which is advantageous in that the method easily produces a field effect semiconductor device which has a current path having carbon nanotubes uniformly dispersed therein, and which is prevented from suffering deterioration of the device characteristics due to the formation of bundles of carbon nanotubes.

Further, the present invention has been achieved for solving the above problems, and a task is to provide a method which is advantageous in that the method can use carbon nanotubes having such excellent properties that the wall structure of each carbon nanotube has fewer defects, and the method easily produces a field effect semiconductor device which has a current path having the carbon nanotubes uniformly dispersed therein, and which has excellent device characteristics including high mobility.

Specifically, the present invention is directed to a method for producing a field effect semiconductor device using carbon nanotubes in a current path, such as a channel layer, wherein the method includes the step of subjecting the carbon nanotubes to plasma treatment to change the carbon nanotubes in physical or chemical state.

Further, the present invention is directed to a method for producing a field effect semiconductor device using carbon nanotubes in a current path, such as a channel layer, wherein the method includes the steps of:

preparing a dispersion liquid of the carbon nanotubes;
applying the dispersion liquid to a predetermined pattern; and
drying the dispersion liquid to form the current path composed of the carbon nanotubes, producing a field effect semiconductor device. (Hereinafter, this method is frequently referred to as "the first method of the present invention".)

Still further, the present invention is directed to a method for producing a field effect semiconductor device using carbon nanotubes in a current path, such as a channel layer, wherein the method includes the steps of:

preparing the carbon nanotubes by a laser ablation process;
preparing a dispersion liquid of the carbon nanotubes;
applying the dispersion liquid to a predetermined pattern; and
drying the dispersion liquid to form the current path comprised of the carbon nanotubes, producing a field effect semiconductor device. (Hereinafter, this method is frequently referred to as "the second method of the present invention".)

BRIEF DESCRIPTION OF THE DRAWINGS

FIGs. 1A and 1B are graphs showing and comparing the two types of $V_g$-$I_{sd}$ characteristics of a field effect transistor in an embodiment of the present invention.
FIGs. 2A to 2C are a structure example of the field effect transistor in the embodiment of the present invention and AFM diagrams of the transistor before being subjected to plasma treatment.
FIGs. 3A and 3B are diagrammatic views showing the molecular structures of carbon nanotubes.
FIG. 4 is a graph of the $V_g$-$I_{sd}$ characteristics of the field effect transistor in an embodiment of the present invention.
FIG. 5 is a graph of the temperature characteristics of the field effect transistor in the embodiment of the present invention.
FIG. 6 is a graph showing the relationship between the temperature and the mobility with respect to the field effect transistor in the embodiment of the present invention.
FIG. 7 is a graph of the $V_g$-$I_{sd}$ characteristics, determined at different temperatures, of the field effect transistor in the embodiment of the present invention.
FIG. 8 is a graph of the $V_{sd}$-$I_{sd}$ characteristics of the field effect transistor in the embodiment of the present invention.
FIG. 9 is a graph of the $V_{sd}$-$I_{sd}$ characteristics of the field effect transistor in the embodiment of the present invention.
FIG. 10 is a graph showing the relationship between the temperature and the current with respect to the field effect transistor in the embodiment of the present invention.
FIG. 11 is a graph showing the relationship between the temperature and the current with respect to the field effect transistor in the embodiment of the present invention.

BEST MODE FOR CARRYING OUT THE INVENTION

In the present invention, the above-described phrase "to change the carbon nanotubes in physical state" means to etch part of the carbon nanotubes by, for example, permitting the carbon nanotubes to undergo oxidation or combustion by the plasma treatment. The above-described phrase "to change the carbon nanotubes in chemical state" means to deliberately lower the conduction by, for example, terminating the walls of part of the carbon nanotubes by atoms of oxygen or the like in the plasma treatment to change the delocalized $\pi$ electrons to $\sigma$ electrons. Excess nanotubes are removed in the former case or excess nanotubes are inhibited from contributing to the carrier conduction in the latter case, thus producing a field effect semiconductor device having desired device characteristics.

In the present invention, it is preferred that the plasma treatment is performed after forming the current path composed of the carbon nanotubes, e.g., a channel layer. In this process, the carbon nanotubes in the form of bundles in the channel layer are subjected to plasma treatment to oxidize or etch the predetermined carbon nanotubes so as to divide the thick bundles, so that the current path composed of the carbon nanotubes having a desired degree of dispersion can be further easily formed.

It is preferred to use RF plasma as the plasma, and oxygen or hydrogen can be used as a plasma source. With respect to the conditions for the plasma treatment, there is no particular limitation, but, for example, with respect to the conditions for oxygen plasma, it is preferred that the power is 15 W or less and the plasma application time is 3 minutes or shorter.

In the formation of the current path, e.g., a channel layer, composed of the carbon nanotubes, when the carbon nanotubes are allowed to grow directly in the current path by a chemical vapor deposition process, the resultant carbon nanotubes have an unfavorable wall structure such that the walls are undulate or contain a carbon 5-membered ring or carbon 7-membered ring. In a field effect semiconductor device produced using the carbon nanotubes having such a wall structure, electrons are likely to be scattered, thus lowering the mobility.

In contrast, carbon nanotubes prepared by, for example, a laser ablation process, which is a high-temperature synthesis method, have such excellent properties that the wall structure of each carbon nanotube is composed substantially solely of carbon 6-membered rings and has fewer defects, and this fact has been confirmed by the examination under an electron microscope (M. Shiraishi et al., Chem. Phys. Lett. 358 (2002) 213.).

In the present invention, it is preferred that the current path composed of the carbon nanotubes, e.g., a channel layer is formed by applying a dispersion of the carbon nanotubes to a predetermined pattern and drying the dispersion applied. Specifically, it is preferred that the selected excellent-property carbon nanotubes are dispersed in a solvent and the resultant dispersion is applied dropwise to a predetermined pattern and then dried. In the method for producing a field effect semiconductor device of the present invention, as the carbon nanotubes, those prepared by a laser ablation process, a chemical vapor deposition process, or an arc discharge process can be used.

In this process, a dispersion of the excellent-property carbon nanotubes is applied to a predetermined pattern and then dried to form the current path composed of the excellent-property carbon nanotubes, e.g., a channel layer, and therefore there can be produced a field effect semiconductor device which has the current path having uniformly dispersed therein only the carbon nanotubes having such excellent properties that the wall structure of each carbon nanotube has fewer defects. In addition, the current path can be formed simply by applying the dispersion of the carbon nanotubes to a predetermined pattern and drying it, thus making the production process easy.

It is preferred that the carbon nanotubes prepared by a laser ablation process are purified and the purified excellent-property carbon nanotubes are dispersed in a solvent, and the resultant dispersion is applied dropwise to a predetermined pattern and then dried. The carbon nanotubes prepared by a laser ablation process, which is a high-temperature synthesis method, have such excellent properties that the wall structure of each carbon nanotube has fewer defects, and these carbon nanotubes are uniformly dispersed and thus, a field effect semiconductor device having excellent performance can be easily produced. A method for the purification is such that, for example, the carbon nanotubes are heated in aqueous hydrogen peroxide under reflux at 100°C for 5 hours and then subjected to ultrasonic treatment in an NaOH solution.

In the present invention, it is preferred that the current path, e.g., a channel layer, is formed so that the degree of dispersion of the carbon nanotubes in the current path becomes 0.1 to 10 tubes/$\mu$m$^2$. When the degree of dispersion of the carbon nanotubes in the current path is more than 10 tubes/$\mu$m$^2$, the field effect semiconductor device may considerably malfunction. This corresponds to carbon nanotubes having a length of 0.1 $\mu$m to 10 $\mu$m based on the percolation theory.

It is preferred to use single-wall carbon nanotubes as the carbon nanotubes. Multi-wall carbon nanotubes can be used, but the single-wall carbon nanotubes are preferred since they can be more easily prepared and have excellent wall perfection and hence are excellent in electron ballistic conduction.

Further, it is preferred to use ethanol or dimethylformamide (DMF) as the solvent.

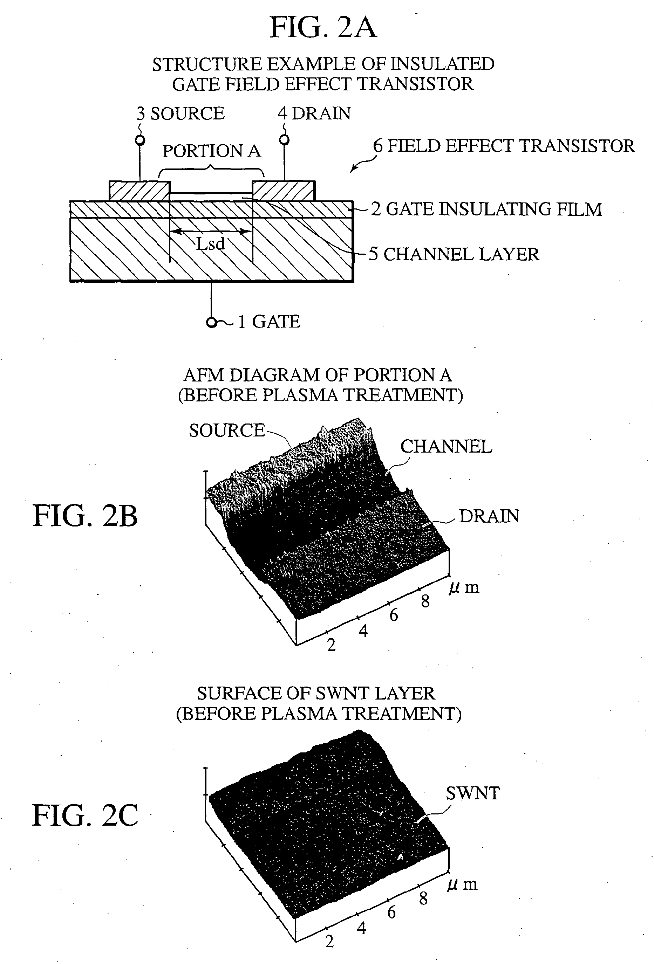

The first method for producing a field effect semiconductor device of the present invention is preferably used to produce a field effect transistor 6, as shown in FIG. 2A, which is configured with: a gate electrode 1; a source electrode 3 and a drain electrode 4, which are formed so that a gate insulating film 2 is disposed between the gate electrode 1 and a pair of the electrodes 3, 4; and a channel layer 5 as the current path formed between the electrodes 3, 4. In this case, a transistor with p-type or/and n-type operations, e.g., transistor 6 can be easily produced. By this method, the number of unnecessary carrier conduction paths of the carbon nanotubes in the channel layer 5 as the current path can be reduced, so that both high mobility and high On/Off ratio can be achieved, thus obtaining excellent device characteristics.

In the second method for producing a field effect semiconductor device of the present invention, it is preferred that the selected excellent-property carbon nanotubes are dispersed in a solvent and the resultant dispersion liquid is applied dropwise to a predetermined pattern and then dried. In this case, as the carbon nanotubes, those prepared by a laser ablation process or a chemical vapor deposition process can be used. In this method, the selected excellent-property carbon nanotubes can be uniformly dispersed, and thus there can be easily produced a field effect semiconductor device having excellent performance such that, for example, the device can operate at a low temperature (e.g., room temperature or lower); and has high mobility.

In the third method for producing a field effect semiconductor device of the present invention, it is preferred that the carbon nanotubes prepared by a laser ablation process are purified and the purified excellent-property carbon nanotubes are dispersed in a solvent, and the resultant dispersion liquid is applied dropwise to a predetermined pattern and then dried. The carbon nanotubes prepared by a laser ablation process, which is a high-temperature synthesis method, have such excellent properties that the wall structure of each carbon nanotube is composed substantially solely of carbon 6-membered rings and has fewer defects, and these carbon nanotubes are uniformly dispersed, and thus there can be easily produced a field effect semiconductor device having excellent performance such that, for example, the device can operate at a low temperature (e.g., room temperature or lower), and has high mobility. Further, the field effect transistor 6 has low activation energy and low current, and hence can operate even at a low temperature (e.g., room temperature or lower) and has high mobility.

In the second or third method for producing a field effect semiconductor device of the present invention, the field effect transistor 6 has low activation energy and low current, and hence can operate even at a low temperature (e.g., room temperature or lower) and has high mobility.

Embodiments

Hereinbelow, preferred embodiments of the present invention will be described with reference to the accompanying drawings.

Example 1

Single-wall carbon nanotubes (SWNTs) were prepared by a laser ablation process using a carbon target containing Ni/Co respectively at 0.6 at%. The temperature for the preparation was 1,200 degrees. The SWNTs prepared were purified successively using aqueous hydrogen peroxide, hydrochloric acid, and an aqueous NaOH solution (M. Shiraishi et al. CPL 358 (2002), 213). Compositional analysis using an electron microscope and EDX, Raman spectroscopy, or the like confirmed that the SWNTs purified had a purity of 95% or more.

The thus obtained SWNTs were dispersed in a dimethylformamide (DMF) solution using ultrasonic waves for 2 hours, and then subjected to centrifugal separation by means of a centrifugal separator (at 4,000 rpm for 15 minutes) to obtain a dispersion liquid composed only of the supernatant in which the SWNTs were well dispersed.

Then, the resultant dispersion liquid was applied dropwise to an $SiO_2$/Si substrate {electrode Fe/Au = 10/200 nm; gate width ($L_{sd}$): 2 $\mu$m; gate length (w): 162.5 $\mu$m; oxide film thickness ($L_{ox}$): 100 nm} having a field effect transistor (FET) structure as shown in FIG. 2A, and then dried. AFM diagrams of the SWNTs from which DMF was removed by drying are shown in FIGs. 2B and 2C. FIG. 2B is an AFM diagram of the portion A shown in FIG. 2A, and FIG. 2C is an AFM diagram of a channel layer 5 comprised of the SWNTs. When using multi-wall carbon nanotubes (MWNTs), the method for preparation is similar to the method mentioned above.

Typically, the SWNTs had a length of 2 $\mu$m to 3 $\mu$m. This indicates that the density of the SWNTs is about 2 to 3 tubes/$\mu$m$^2$ on average based on the percolation theory. It has been found that, in a case where the density of the SWNTs is more than 10 tubes/$\mu$m$^2$, the field effect transistor considerably malfunctions.

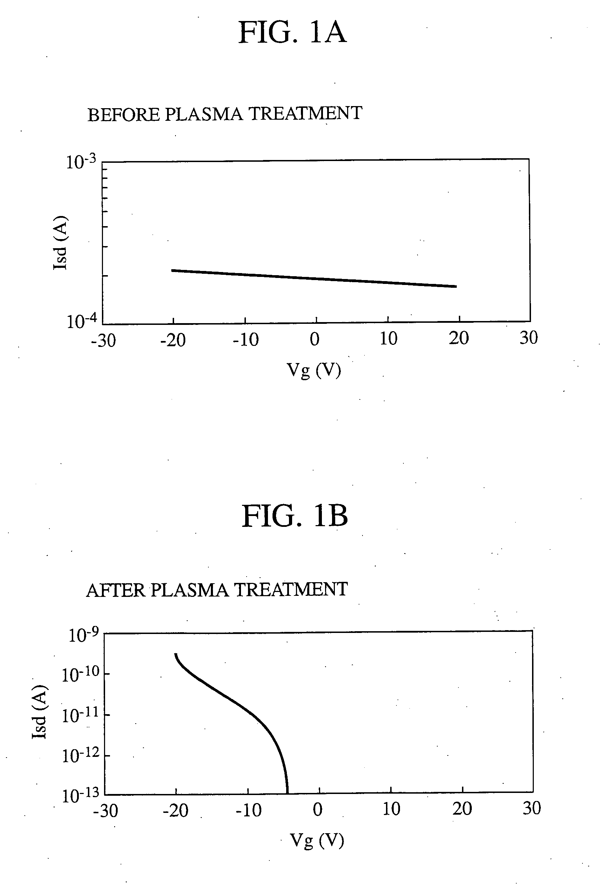

With respect to the SWNT-FET prepared by the above-mentioned method, FET characteristics were measured under conditions at 300 K. The results are shown in FIG. 1A. A voltage ($V_{sd}$) between source/drain electrodes of 0.1 V was fixed, and a change of the current ($I_{sd}$) between the source/drain electrodes with the gate voltage was measured. As can be seen from FIG. 1A, a current tends to flow on the negative gate side, which indicates that the operation of the SWNT-FET is p-type. Further, it is apparent that the SWNT-FET has p-type or n-type ambipolar transistor operation characteristics.

Using the channel length ($L_{sd}$), the gate length (w), the dielectric constant ($\varepsilon$ (= 4.0)) of $SiO_2$, the thickness ($L_{ox}$) of the $SiO_2$ oxide film, and the like, a mobility ($\mu$) can be represented by the following Equation (1) :

$$\mu_{eff} = \frac{dI_{sd}}{dV_g} \times \frac{L_{ox}L_{sd}}{\varepsilon V_{sd} W}$$

---Equation 1.

The mobility determined from the Equation (1) was about 5 $cm^2$/Vs. However, the On/Off ratio was a value in a single digit or smaller, indicating that the device had problems from a practical point of view.

Next, this device was subjected to oxygen plasma treatment. When using, instead of oxygen, gas having an etching or oxidizing property to cause the carbon nanotubes to suffer an appropriate damage, for example, hydrogen, the similar effect can be obtained. Conditions for the oxygen plasma treatment were such that the power was 15 W and the time was 3 minutes. With respect to the conditions including the power and time, there is no particular limitation, but, for example, with respect to the oxygen plasma, it is preferred that the power is 15 W or less and the plasma application time is 3 minutes or shorter.

With respect to the device which had been subjected to plasma treatment, FET characteristics were measured in the same manner as in the measurement mentioned above. The results are shown in FIG. 1B. As can be seen from FIG. 1B, the On/Off ratio is increased to be a value in three digits or more. The mobility is $6 \times 10^{-3} cm^2$/Vs, namely, is reduced by three digits, but this mobility is larger by two digits than the mobility obtained when, e.g., $Alq_3$ is used as a material for the channel layer, and it is equivalent to the mobility obtained when triphenyldiamine (TPD) is used, and thus the mobility is satisfactory in the organic FET device.

As apparent from the above, in the method of the present invention, the carbon nanotubes were subjected to plasma treatment to change the carbon nanotubes in physical or chemical state, and therefore the number of unnecessary carrier conduction paths of the carbon nanotubes in the channel layer could be reduced, so that both high mobility and high On/Off ratio could be achieved, making it possible to easily produce a field effect transistor having excellent device characteristics.

In addition, the carbon nanotubes prepared by a laser ablation process were purified and the purified excellent-property carbon nanotubes were dispersed in a solvent, and the resultant dispersion liquid was applied dropwise to a predetermined pattern and then dried to form the channel layer composed of the carbon nanotubes, and therefore there could be produced a field effect transistor which has the channel layer having uniformly dispersed therein only the carbon nanotubes having such excellent properties that the wall structure of each carbon nanotube has fewer defects. Further, the channel layer could be formed simply by applying the dispersion of the carbon nanotubes to a predetermined pattern and drying it, thus making the production process easy.

Example 2

Single-wall carbon nanotubes (SWNTs) were prepared by a laser ablation process using a carbon target containing Ni/Co respectively at 0.6 at%. The temperature for the preparation was 1,200 degrees. The SWNTs prepared were purified successively using aqueous hydrogen peroxide, hydrochloric acid, and an aqueous NaOH solution (M. Shiraishi et al. CPL 358 (2002), 213). Compositional analysis using an electron microscope and EDX, Raman spectroscopy, or the like confirmed that the SWNTs purified had a purity of 95% or more.

The thus obtained SWNTs were dispersed in a dimethylformamide (DMF) solution using ultrasonic waves for 2 hours, and then subjected to centrifugal separation by means of a centrifugal separator (at 4,000 rpm for 15 minutes) to extract only the well dispersed SWNT in the supernatant.

Then, the resultant dispersion liquid was applied dropwise to an $SiO_2$/Si substrate (electrode Fe/Au = 10/200 nm; gate width ($L_{sd}$): 20 $\mu$m; gate length (w): 330 $\mu$m; oxide film thickness ($L_{ox}$): 100 nm) having a field effect transistor (FET) structure as shown in FIG. 2A, and then dried. AFM diagrams of the SWNTs from which DMF was removed by drying are shown in FIGs. 2B and 2C. FIG. 2B is an AFM diagram of the portion A shown in FIG. 2A, and FIG. 2C is an AFM diagram of a channel layer 5 composed of the SWNTs.

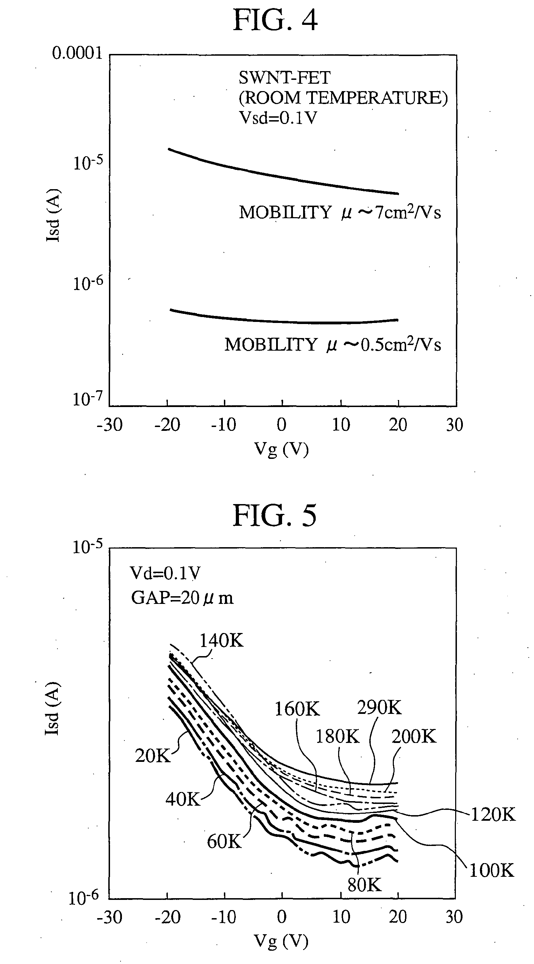

FIG. 4 is a graph showing the operation characteristics of the SWNT-FET prepared by the above-mentioned method. A voltage ($V_{sd}$) between source/drain electrodes was fixed to 0.1 V, and a change of the current ($I_{sd}$) between the source/drain electrodes with the gate voltage was measured. The experiment was conducted at room temperature. As can be seen from FIG. 4, a current tends to flow on the negative gate side, which indicates that the operation of the SWNT-FET is p-type. The polarity of the SWNTs is consistent with those that have been reported.

Using the channel length ($L_{sd}$), the gate length (w), the permittivity ($\varepsilon$(= 4.0)) of $SiO_2$, the thickness ($L_{ox}$) of the $SiO_2$ oxide film, and the like, a mobility ($\mu$) can be represented by the Equation (1) shown above.

It was found that an FET having a mobility, determined from the Equation (1), as high as about 0.5 to 7 cm$^2$/Vs was obtained. A satisfactory mobility could be obtained in the room temperature region, as compared to that of conventional organic FETs. For example, FETs using fullerene molecules ($C_{60}$) as a material for the channel layer have a mobility of 0.6 cm$^2$/Vs at most, condensed aromatic compounds FETs using pentacene or the like have a mobility of 2 to 5 cm$^2$/Vs at most, and FETs using other materials have a mobility of 10 to 2 cm$^2$/Vs at most, whereas, the FET in the present invention has a mobility (0.5 to 7 cm$^2$/Vs) comparable with that of a polysilicon or amorphous silicon device.

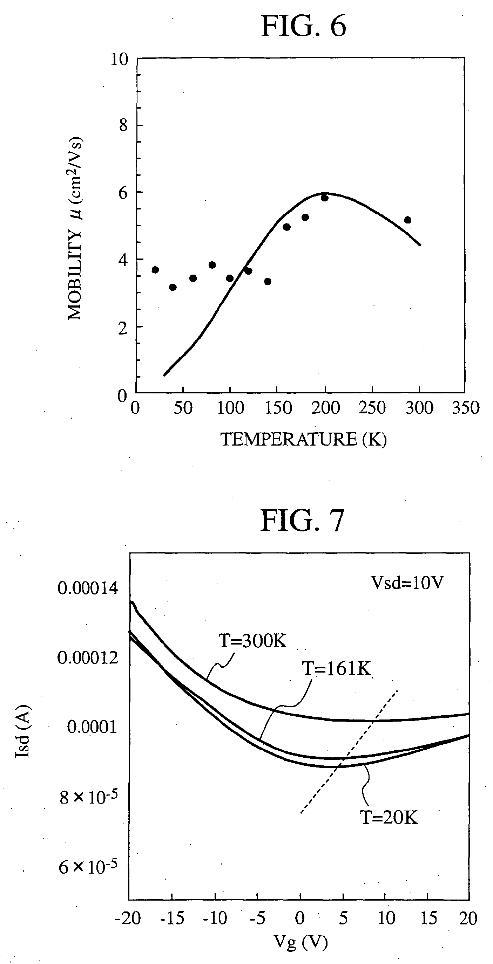

Next, the temperature characteristics of the device operation and the temperature characteristics of the mobility were measured. The results are shown in FIGs. 5 and 6. The mobility has been studied with respect to silicon, and fitting using the formula obtained in the studies is shown by a curved line in FIG. 6.

As can be seen from FIG. 6, the silicon device does not appropriately operate on the low temperature side. In a crystal system, carriers freeze out at low temperatures and hence the mobility is nearly zero, that is, the device stops operating. By contrast, the SWNT-FET produced by the method of the present invention, as seen from FIGs. 5 and 6, was confirmed to operate as a device even at a low temperature while maintaining the mobility substantially equivalent to the mobility obtained at room temperature. That is, the SWNT-FET produced by the method of the present invention is advantageous not only in that it has a mobility higher than that of the devices using other organic materials, but also in that it guarantees the operation at low temperatures, which cannot be achieved by crystalline semiconductors composed of Si or the like.

FIG. 7 is a graph showing the results of the measurement of $I_{sd}$-$V_g$ characteristics at different measurement temperatures with respect to the sample device prepared by the above-mentioned method. The voltage ($V_{sd}$) between source/drain electrodes was set to 10 V. This sample device was of an FET structure of SiO$_2$/Si substrate (electrode Fe/Au = 10/200 nm; gate width ($L_{sd}$): 20 $\mu$m; gate length (w): 330 $\mu$m; oxide film thickness ($L_{ox}$) : 100 nm) as shown in FIGs. 2A to 2C. As can be seen from FIG. 7, a device operation substantially similar to that achieved at room temperature was possible even in an environment at a low temperature. Further, it is apparent that the sample device has p-type or n-type ambipolar transistor operation characteristics.

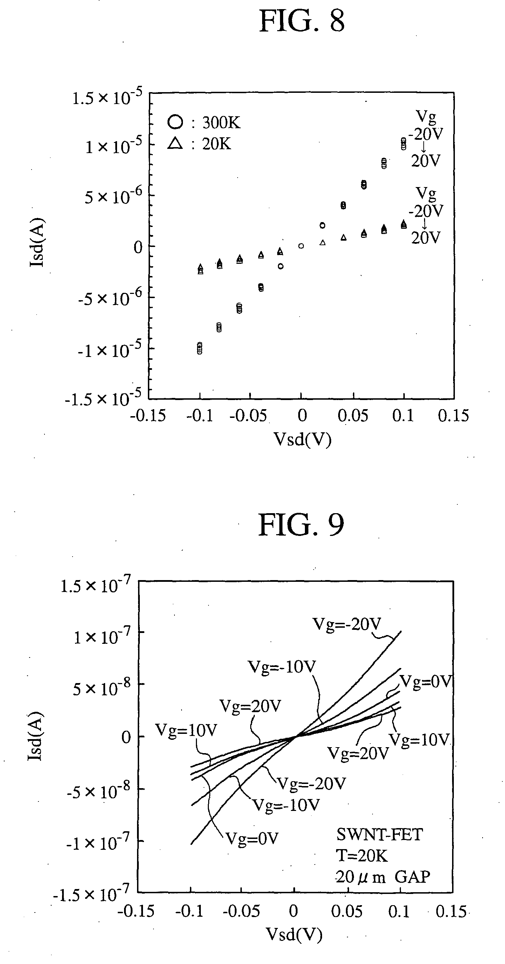

FIG. 8 is a graph showing the results of the measurement of $I_{sd}$-$V_{sd}$ characteristics with different gate voltages ($V_g$) and at different measurement temperatures with respect to the sample device prepared by the above-mentioned method. This sample device was of an FET structure of SiO$_2$/Si substrate (electrode Fe/Au = 10/200 nm; gate width ($L_{sd}$): 20 $\mu$m; gate length (w): 330 $\mu$m; oxide film thickness ($L_{ox}$): 100 nm) as shown in FIGs. 2A to 2C. As can be seen from FIG. 8, a device operation was possible even in an environment at a low temperature.

FIG. 9 is a graph showing the results of the measurement of $I_{sd}$-$V_{sd}$ characteristics with different gate voltages ($V_g$) with respect to the sample device prepared by the above-mentioned method. The measurement temperature was 20 K. This sample device was of an FET structure of SiO$_2$/Si substrate (electrode Fe/Au = 10/200 nm; gate width ($L_{sd}$) : 20 $\mu$m; gate length (w): 330 $\mu$m; oxide film thickness ($L_{ox}$): 100 nm) as shown in FIGs. 2A to 2C. As can be seen from FIG. 9, a device operation was possible even in an environment at a low temperature.

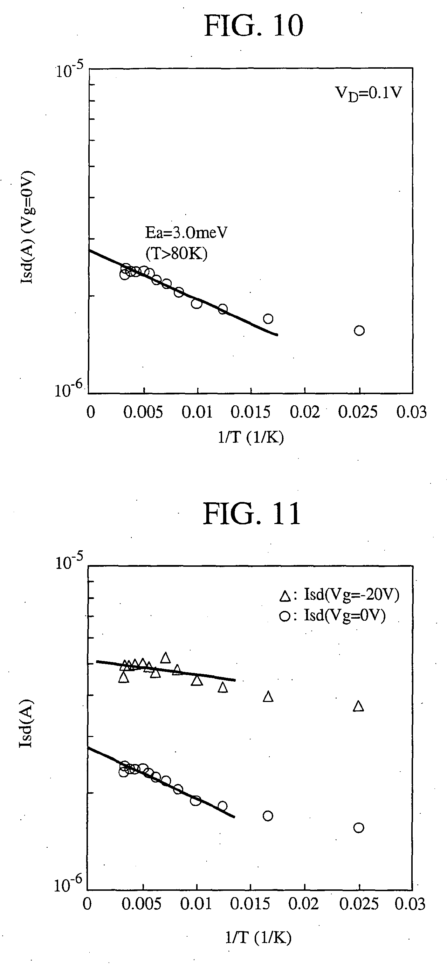

FIG. 10 is a graph showing the relationship between the measurement temperature and the current ($I_{sd}$) between source/drain electrodes measured with respect to the sample device prepared by the above-mentioned method. The voltage ($V_{sd}$) between the source/drain electrodes was set to 0.1 V, and the gate voltage was set to 0 V. This sample device was of an FET structure of SiO$_2$/Si substrate (electrode Fe/Au = 10/200 nm; gate width ($L_{sd}$): 20 $\mu$m; gate length (w): 330 $\mu$m; oxide film thickness ($L_{ox}$): 100 nm) as shown in FIGs. 2A to 2C. As can be seen from FIG. 10, when the environment temperature was 80 K or higher, the activation energy was as very small as 3 meV. For example, instead of the SWNTs in the channel layer of the device, when using fullerene molecules ($C_{60}$), the activation energy is 90 meV, when using fullerene molecules ($C_{70}$), it is 110 meV, when using pentacene, it is 16 meV, and, when using Cu-PC (copper phthalocyanine), it is 160 meV. From the results, it is apparent that the SWNT-FET has low activation energy and low current and hence can operate even in an environment at a low temperature.

FIG. 11 is a graph showing the relationship between the measurement temperature and the current ($I_{sd}$) between source/drain electrodes measured with respect to the sample device prepared by the above-mentioned method. The measurement was conducted in a condition of gate voltage ($V_g$) set to 0 V or -20 V. This sample device was of an FET structure of SiO$_2$/Si substrate (electrode Fe/Au = 10/200 nm; gate width ($L_{sd}$): 20 $\mu$m; gate length (w): 330 $\mu$m; oxide film thickness ($L_{ox}$): 100 nm) as shown in FIGS. 2A to 2C. From the results, it is apparent that the application of the gate voltage surely applies an electric field to the carbon nanotubes forming the channel layer.

As apparent from the above, in the method for producing a field effect semiconductor device according to the present invention, the carbon nanotubes prepared by a laser ablation process were purified and the purified excellent-property carbon nanotubes were dispersed in a solvent, and the resultant dispersion liquid was applied dropwise to a predetermined pattern and then dried to form the channel layer composed of the carbon nanotubes, and therefore there could be produced a field effect transistor which has the channel layer having uniformly dispersed therein only the carbon nanotubes having such excellent properties that the wall structure of each carbon nanotube has fewer defects. In addition, the channel layer could be formed simply by applying the dispersion liquid of the carbon nanotubes to a predetermined pattern and drying it, thus making the production process easy. Accordingly, the field effect transistor obtained by this method had excellent performance such that, for example, the transistor operates at a low temperature, and has high mobility.

Hereinabove, the embodiments and examples of the present invention are described, but they can be changed or modified based on the technical concept of the present invention.

INDUSTRIAL APPLICABILITY

According to the present invention, the method includes the step of subjecting the carbon nanotubes to plasma treatment to change the carbon nanotubes in physical or chemical state, and therefore the carbon nanotubes can be reduced in the number of conduction paths, and thus a field effect semiconductor device having a current path having the carbon nanotubes uniformly dispersed therein and having excellent device performance (device characteristics) can be easily produced.

Further, according to the present invention, the method includes the step of applying a dispersion liquid of the carbon nanotubes to a predetermined pattern and drying the dispersion liquid to form the current path composed of the carbon nanotubes, e.g., a channel layer, and, for example, selection of the carbon nanotubes is conducted in the stage in which the dispersion liquid is prepared, and only the selected excellent-property carbon nanotubes are used, thus producing a field effect semiconductor device which has the current path having uniformly dispersed therein only the carbon nanotubes having such excellent properties that the wall structure of each carbon nanotube has fewer defects, and which has high mobility. In addition, the current path can be formed simply by applying the dispersion liquid of the carbon nanotubes to a predetermined pattern and drying it, thus making the production process easy. Accordingly, the field effect semiconductor device obtained by this method has, for example, low activation energy and low current, and hence has excellent performance such that the device advantageously operates even at a low temperature.

Further, by virtue of the step of preparing the carbon nanotubes by a laser ablation process, the selection of the excellent-property carbon nanotubes as mentioned above is not needed, and there can be prepared by laser ablation the carbon nanotubes having such excellent properties that the wall structure of each carbon nanotube is composed substantially solely of carbon 6-membered rings and has fewer defects, thus making the production process more easy.

**Claims**

1. A method for producing a field effect semiconductor device using carbon nanotubes in a current path, the method including the step of subjecting said carbon nanotubes to plasma treatment to change a physical or chemical state of said carbon nanotubes.

2. The method for producing a field effect semiconductor device according to claim 1, wherein said plasma treatment is performed after forming said current path composed of said carbon nanotubes.

3. The method for producing a field effect semiconductor device according to claim 1, which uses single-wall carbon nanotubes as said carbon nanotubes.

4. The method for producing a field effect semiconductor device according to claim 1, which uses RF plasma as said plasma.

5. The method for producing a field effect semiconductor device according to claim 1, which uses oxygen or hydrogen as a plasma source for said plasma treatment.

6. The method for producing a field effect semiconductor device according to claim 1, wherein said current path composed of said carbon nanotubes is formed by applying a dispersion liquid of said carbon nanotubes to a predetermined pattern and drying the dispersion applied.

7. The method for producing a field effect semiconductor device according to claim 6, wherein the selected excellent-property carbon nanotubes are dispersed in a solvent and the resultant dispersion liquid is applied dropwise to a predetermined pattern and then dried.

8. The method for producing a field effect semiconductor device according to claim 1, wherein said carbon nanotubes are prepared by a laser ablation process or a chemical vapor deposition process.

9. The method for producing a field effect semiconductor device according to claim 1, wherein said current path is

**EP 1 667 238 A1**

formed so that the degree of dispersion of said carbon nanotubes in said current path becomes 0.1 to 10 tubes/$\mu m^2$.

10. The method for producing a field effect semiconductor device according to claim 1, wherein said carbon nanotubes used have a length of 0.1 $\mu$m to 10 $\mu$m.

11. The method for producing a field effect semiconductor device according to claim 7, which uses ethanol or dimethylformamide as said solvent.

12. The method for producing a field effect semiconductor device according to claim 1, which produces a field effect transistor comprising: a gate electrode; a source electrode and a drain electrode, which are formed so that a gate insulating film is disposed between said gate electrode and said source and drain electrodes; and a channel layer as said current path formed between said source and drain electrodes.

13. The method for producing a field effect semiconductor device according to claim 1 or 12, which produces a transistor with p-type or/and n-type operations.

**9**

# FIG. 1A

BEFORE PLASMA TREATMENT

# FIG. 1B

AFTER PLASMA TREATMENT

# FIG. 2A

STRUCTURE EXAMPLE OF INSULATED
GATE FIELD EFFECT TRANSISTOR

3 SOURCE      4 DRAIN

PORTION A      6 FIELD EFFECT TRANSISTOR

2 GATE INSULATING FILM

Lsd

5 CHANNEL LAYER

1 GATE

AFM DIAGRAM OF PORTION A
(BEFORE PLASMA TREATMENT)

SOURCE      CHANNEL

FIG. 2B      DRAIN

$\mu$ m

8
6
4
2

SURFACE OF SWNT LAYER
(BEFORE PLASMA TREATMENT)

SWNT

FIG. 2C

$\mu$ m

8
6
4
2

# FIG. 3A

41

EDGES ARE JOINED TOGETHER
TO FORM A CYLINDRICAL ROLL

42

43

44

45

FIG. 3B

## FIG. 4

SWNT-FET
(ROOM TEMPERATURE)
Vsd=0.1V

MOBILITY $\mu \sim 7 cm^2/Vs$

MOBILITY $\mu \sim 0.5 cm^2/Vs$

## FIG. 5

Vd=0.1V
GAP=20$\mu$m

140K

160K    290K

180K    200K

20K

40K

60K

120K

80K    100K

# FIG. 6

# FIG. 7

# FIG. 8

# FIG. 9

## FIG. 10

## FIG. 11

## INTERNATIONAL SEARCH REPORT

| International application No. |
|---|
| PCT/JP2004/013285 |

| A. CLASSIFICATION OF SUBJECT MATTER |
|---|
| Int.Cl⁷  H01L29/786, H01L29/06 |

According to International Patent Classification (IPC) or to both national classification and IPC

| B. FIELDS SEARCHED |
|---|

Minimum documentation searched (classification system followed by classification symbols)
Int.Cl⁷  H01L29/786, H01L29/06

Documentation searched other than minimum documentation to the extent that such documents are included in the fields searched
Jitsuyo Shinan Koho          1922–1996   Jitsuyo Shinan Toroku Koho   1996–2004
Kokai Jitsuyo Shinan Koho     1971–2004   Toroku Jitsuyo Shinan Koho   1994–2004

Electronic data base consulted during the international search (name of data base and, where practicable, search terms used)
JICST FILE(JOIS) [NANOCHUBU*TORANJISUTA] (in Japanese)

| C. DOCUMENTS CONSIDERED TO BE RELEVANT |
|---|

| Category* | Citation of document, with indication, where appropriate, of the relevant passages | Relevant to claim No. |
|---|---|---|
| Y | PHILIP G. COLLINS, MICHAEL S. ARNOLD, PHAEDON AVOURIS, 'Engineering Carbon Nanotubes and Nanotube Circuits Using Electrical Breakdown', Science, 27 April, 2001 (27.04.01), Vol.292, No.5517, pages 706 to 709 | 1–13 |
| Y | JP 2002-201014 A  (Honda Motor Co., Ltd.), 16 July, 2002 (16.07.02), Par. Nos. [0002] to [0003] & US 2002/0090468 A1 | 1–13 |
| Y | JP 2002-234000 A  (NEC Corp.), 20 August, 2002 (20.08.02), Par. Nos. [0031], [0051], [0056] & WO 2002/045113 A1 | 1–13 |

| [X]  Further documents are listed in the continuation of Box C. | [ ]  See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 30 November, 2004 (30.11.04) | 14 December, 2004 (14.12.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
|---|
| PCT/JP2004/013285 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2001-167692 A  (Lucent Technologies Inc.), 22 June, 2001 (22.06.01), Par. No. [0038] & EP 1100106 A2 | 1-13 |
| Y | JP 2003-179234 A  (Konica Corp.), 27 June, 2003 (27.06.03), Par. Nos. [0012], [0016] to [0017] & EP 1291932 A2 | 6-7,11 |
| Y | JP 2003-017508 A  (NEC Corp.), 17 January, 2003 (17.01.03), Par. No. [0021] (Family: none) | 8 |

Form PCT/ISA/210 (continuation of second sheet) (January 2004)